# EUROPÄISCHE PATENTSCHRIFT

(11) **EP 1 214 733 B1**
(45) Veröffentlichungstag und Bekanntmachung des Hinweises auf die Patenterteilung: **09.05.2007**
(21) Anmeldenummer: 00966057.2
(22) Anmeldetag: 20.09.2000
(51) Int. Cl.: H01L 21/00

(54) **VORRICHTUNG ZUM BE- UND ENTLADEN VON SUBSTRATEN**
DEVICE FOR LOADING AND UNLOADING SUBSTRATES
DISPOSITIF DE CHARGEMENT ET DE DECHARGEMENT DE SUBSTRATS

(30) Priorität: 23.09.1999 DE 19945648
(43) Veröffentlichungstag der Anmeldung: 19.06.2002
(73) Patentinhaber: HamaTech AG, 75447 Sternenfels (DE)
(72) Erfinder: WEBER, Klaus, 75015 Bretten (DE); SÄMANN, Martin, 75443 Ötisheim (DE); KALLIS, Jürgen, 75417 Mühlacker (DE)
(74) Vertreter: Wagner & Geyer
(86) Internationale Anmeldenummer: PCT/EP2000/009177
(87) Internationale Veröffentlichungsnummer: WO 2001/022477

(56) Entgegenhaltungen:
- US-A- 4 805 759
- US-A- 4 981 408
- US-A- 5 339 128
- US-A- 5 863 170

## Beschreibung

Die vorliegende Erfindung bezieht sich auf eine Anlage gemäß dem Oberbegriff des Anspruchs 1, die eine Vorrichtung zum Be- und Entladen von Substraten aufweist mit einer Fördereinrichtung zum linearen Transport der Substrate und wenigstens einer drehbaren Handhabungsvorrichtung zum Transport der Substrate zwischen der Fördereinrichtung und wenigstens einer Prozeßstation.

Vorrichtungen zum Be- und Entladen von Substraten der obigen Art sind beispielsweise in Anlagen zur Behandlung von Substraten und insbesondere in Anlagen zur Belackung bzw. Beschichtung von Substraten bekannt. Dort werden Substrate, wie beispielsweise CD/CD-R/DVD und andere Datenspeicher bzw. Datenträger zur Belackung bzw. zum Beschichten durch eine erste Handhabungsvorrichtung von einer Zuführeinrichtung entnommen und auf einer Prozeßstation, wie beispielsweise einer Belackungsstation, abgelegt. Nach der Bearbeitung wird das Substrat wieder durch eine zweite Handhabungsvorrichtung aufgenommen und auf einer Einrichtung zum Abtransport abgelegt bzw. einem weiteren Prozeß zugeführt.

Aus der US-A-4,824,309 ist eine Anlage gemäß dem Oberbegriff des Anspruchs 1 bekannt. Aus diesem Dokument ist eine Vakuumprozesseinheit mit einer Vakuumvorkammer, einer Pufferkammer und einer Prozesskammer bekannt. Die Einheit weist einen ersten Waferträger in der Pufferkammer auf, sowie einen zweiten Waferträger, um Wafer von der Vakuumvorkammer zu dem ersten Waferträger in der Pufferkammer zu transportieren. Ferner ist ein dritter Waferträger vorgesehen, der den Wafer von dem ersten Waferträger zur Prozesskammer transportiert, wobei die zweiten und dritten Waferträger Förderbänder aufweisen.

Das Speedline Prospekt der Firma Leybold, 2/97, Seiten 6 bis 9 zeigt eine integrierte CD-Herstellungsvorrichtung, bei der unterschiedliche Prozesseinheiten zur Herstellung von CD's in einer Anlage integriert sind. Zum Transport von Elementen, welche die CD bilden, werden sowohl Förderbänder als auch mechanische Greifer eingesetzt.

Die DE-C-197 22 408 zeigt eine Vorrichtung und ein Verfahren zum getrennten Transportieren von Substraten auf zwei getrennten Transportstrecken, mit zwei Zuführstationen, mindestens zwei Prozessstationen und zwei Ausgabestationen. Eine Transporteinrichtung zum Transport der Substrate ist um einen ersten Winkel um eine Drehachse drehbaren und weist mindestens zwei auf einem Kreisbogen um die Drehachse in einem vorgegebenen Winkelabstand angeordneten Greifern auf. Der Winkelabstand zwischen den zwei Zuführstationen zwischen den zwei Prozessstationen und zwischen den zwei Abgabestationen ist jeweils gleich dem vorgegebenen Winkelabstand, und der erste Winkel ist größer als der vorgegebene Winkel.

Aus der DE-C-41 27 341 ist ferner eine Vorrichtung zum Durchführen unterschiedlicher Prozesse an einem Werkstück bekannt. Die Werkstücke werden über einen linear bewegbaren Transportschlitten mit jeweils drei beiderseits des Schlittens angeordneten Transportarmen zu einem Rundschalttisch hin und von diesem weg transportiert. Der Rundschalttisch führt die Werkstücke unterschiedlichen Prozesstationen zu.

Ferner sei auf die US-A- 5,700,127 verwiesen, die eine Substratbehandlungsvorrichtung mit unterschiedlichen Prozesseinheiten aufweist. Die Substrate werden den unterschiedlichen Prozesseinheiten über eine Handhabungseinrichtung zugeführt und aus diesen entnommen. Die Handhabungseinrichtung weist einen Substratgreifer auf, der in x-, y- und z-Richtung linear bewegbar und um die z-Achse herum drehbar ist.

Bei solchen Vorrichtungen sind zum Be- und Entladen einer Prozeßstation separate Handhabungsvorrichtungen sowie separate Zuführ- und Abtransporteinrichtungen vorgesehen. Hierdurch ergibt sich ein hoher Platzbedarf für die Vorrichtungskomponenten, was insbesondere in Reinstraumumgebungen zu hohen Kosten führt.

Ausgehend von solchen Vorrichtungen liegt der vorliegenden Erfindung die Aufgabe zugrunde, eine kostengünstige Vorrichtung mit einer geringen Anzahl von Komponenten und geringerem Platzbedarf vorzusehen.

Diese Aufgabe wird erfindungsgemäß bei der Anlage gemäß Anspruch 1 gelöst, wobei die Fördereinrichtung zwischen wenigstens zwei Prozeßstationen und die wenigstens eine Handhabungsvorrichtung oberhalb der Fördereinrichtung angeordnet ist. Die Anordnung der Fördereinrichtung zwischen wenigstens zwei Prozeßstationen hat den Vorteil, daß durch die oberhalb der Fördereinrichtung angeordnete drehbare Handhabungsvorrichtung mehrere Prozeßstationen bei geringem Platzbedarf bestückt werden können.

Gemäß einer bevorzugten Ausgestaltung liegt der Drehpunkt der Handhabungsvorrichtung auf einer Mittelachse der Fördereinrichtung. Vorzugsweise weist die Handhabungsvorrichtung auf einem Umfangskreis angeordnete Aufnahmevorrichtungen für die Substrate auf, die vorzugsweise auf dem Umfangskreis gleichmäßig beabstandet sind. Dies ergibt eine Kreissymmetrie, die durch eine Drehbewegung der Handhabungsvorrichtung die einfache Be- und Entladung mehrerer Prozeßstationen ermöglicht.

Um zu ermöglichen, daß die Prozeßstationen während der Bearbeitung von Substraten nicht abgedeckt sind und Medienverschleppungen vermieden werden, sind die Aufnahmen vorzugsweise an radialen Armen der Handhabungsvorrichtung angeordnet, um dazwischen Freiräume vorzusehen.

Vorteilhafterweise ist die lineare Fördereinrichtung ein Förderband, das sich vorzugsweise zwischen einer Beladestation und einer Entladestation erstreckt. Dies hat den Vorteil, daß zum Zuführen und zum Abtransportieren der Substrate nur ein einzelnes Förderband benötigt wird, wodurch sich die Anzahl der benötigten Komponenten reduziert.

Gemäß einer besonders bevorzugten Ausführungsform weist das Förderband Träger für einen sicheren Halt und eine definierte Positionierung der Substrate auf. Dabei ist es vorteilhaft, daß die Träger in Bewegungsrichtung auf dem Förderband gleichmäßig beabstandet sind, um die Steuerung des Förderbandes zu vereinfachen, indem gleichbleibende Bewegungsintervalle vorgesehen werden können. Für die Bildung einer Symmetrie zur Handhabungsvorrichtung sind die Träger auf der Mittelachse des Förderbands oder wenigstens zwei Träger symmetrisch zur Mittelachse des Förderbands angeordnet, was die Steuerung der Handhabungsvorrichtung vereinfacht.

Ebenso ist es von Vorteil, wenn wenigstens zwei Träger zum Be- und Entladen der Substrate auf dem Umfangskreis angeordnet sind, um das gleichzeitige Aufnehmen bzw. Ablegen mehrerer Substrate zu ermöglichen.

Gemäß einer bevorzugten Ausführungsform sind Aufnahmemittelpunkte der Prozeßstationen auf dem Umfangskreis, vorzugsweise paarweise diametral auf dem Umfangskreis gegenüberliegend angeordnet.

Dabei sind die Prozeßstationen vorzugsweise innerhalb der Paare vom gleichen Typ. Dies erhöht wiederum die Symmetrie der Vorrichtung und vereinfacht somit die Steuerung der Handhabungsvorrichtung.

Es ist von besonderem Vorteil, wenn auf dem Umfangskreis benachbart angeordnete Prozeßstationen mit dem gleichen Antrieb versehen werden, was die Anzahl der benötigten Antriebe und der damit verbundenen Kosten reduziert.

Vorteilhafterweise entspricht die Anzahl der Aufnahmevorrichtungen der Handhabungsvorrichtung der Anzahl der auf dem Umfangskreis angeordneten Träger und der Prozeßstationen. Dies ermöglicht ein effektives Be- und Entladen aller Prozeßstationen und Träger auf dem Umfangskreis in einem Arbeitsgang. Dabei sind vorzugsweise beim Be- und Entladen alle Aufnahmen entweder über den Trägern auf der Fördereinrichtung oder über den Aufnahmepunkten der Prozeßstationen angeordnet.

Gemäß einer bevorzugten Ausführungsform ist eine Steuervorrichtung zum simultanen Öffnen und Schließen der Aufnahmevorrichtungen der Handhabungsvorrichtung vorgesehen, um die Substrate gleichzeitig von den Trägern und den Prozeßstationen aufzunehmen bzw. auf diese abzulegen.

Die Erfindung wird nachstehend anhand bevorzugter Ausführungsbeispiele unter Bezugnahme auf die Figuren näher erläutert. Es zeigen:
- Figur 1: eine Draufsicht auf eine Anlage mit einer Vorrichtung zum Beund Entladen von Substraten gemäß einem ersten Ausführungsbeispiel der Erfindung;
- Figur 2: eine Draufsicht auf eine Anlage mit einer Vorrichtung zum Beund Entladen von Substraten gemäß einem zweiten Ausführungsbeispiel;
- Figur 3: eine Draufsicht auf eine Anlage mit einer Vorrichtung zum Beund Entladen von Substraten gemäß einem dritten Ausführungsbeispiel.

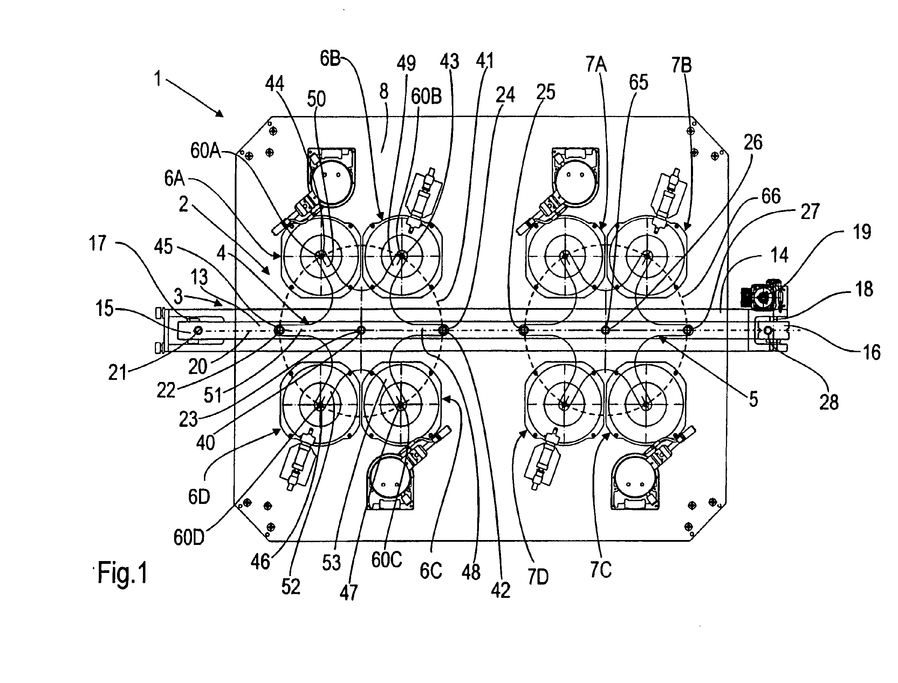

Figur 1 zeigt eine Anlage 1 für die Bearbeitung von CDs. Die Anlage 1 umfaßt eine erste Ausführungsform einer Vorrichtung 2 zum Be- und Entladen von Substraten gemäß der vorliegenden Erfindung, die eine lineare Fördereinrichtung 3 und zwei Handhabungsvorrichtungen 4 und 5 aufweist. Ferner besitzt die Anlage 1 acht Prozeßstationen 6A bis D und 7A bis D, auf denen die CDs bearbeitet werden. Die Anlage 1 ist auf einem Grundkörper bzw. Träger 8 angeordnet, der beispielsweise ein Mineralgußblock ist.

Die Handhabungsvorrichtung 4, die Prozeßstationen 6A bis D und die lineare Fördereinrichtung 3 bilden zusammen eine erste Gruppe der Anlage 1. Weiter bilden die Handhabungsvorrichtung 5, die Prozeßstationen 7A bis D zusammen mit der linearen Fördereinrichtung 3 eine der ersten Gruppe entsprechende zweite Gruppe der Anlage 1. Die erste und die zweite Gruppe der Anlage verwenden gemeinsam die eine lineare Fördereinrichtung 3.

Die lineare Fördereinrichtung 3 der Vorrichtung 2 des ersten Ausführungsbeispiels weist ein Förderband 13 auf, das entlang einer Bahn 14 läuft. Das Förderband 13 ist an Umlenkenden 15 und 16 der Fördereinrichtung 3 auf einer Leerlaufrolle 17 bzw. auf einer Antriebsrolle 18 gelagert. Am Ende 16 der linearen Fördereinrichtung 3 ist ein Antrieb 19 vorgesehen. Der Antrieb 19 ist ein Servomotor mit einer geeigneten, nicht gezeigten Steuervorrichtung, der die Antriebsrolle 18 zum Transport des Förderbandes 13 antreibt.

Die lineare Fördereinrichtung 3 weist eine Mittelachse 20, die zugleich die Mittelachse des Förderbandes 13 ist, auf.

Auf dem Förderband 13 sind Träger für nicht gezeigte CDs angeordnet. In Figur 1 sind acht Träger 21 bis 28 gezeigt. Die Träger 21 bis 28 sind auf der Mittelachse 20 des Förderbandes 13 in einem gleichmäßigen Abstand d angeordnet.

Benachbart zu den Umlenkenden 15 und 16 der Fördereinrichtung 3 befinden sich nicht gezeigte Handhabungsvorrichtungen zum Be- und Entladen der CDs. In Fig. 1 werden die CDs am Umlenkende 15 auf das Förderband 13 durch eine geeignete nicht gezeigte Handhabungsvorrichtung aufgelegt und am Umlenkende 16 nach der Bearbeitung durch eine weitere geeignete, nicht gezeigt Handhabungsvorrichtung wieder entnommen.

Die Handhabungsvorrichtungen 4 und 5 sind über geeignete Antriebe sowohl drehbar als auch höhenverstellbar und über dem Förderband 13 von oben gehalten angeordnet. Da die Handhabungsvorrichtungen 4 und 5 im wesentlichen gleich sind, soll in der Folge nur die Handhabungsvorrichtung 4 beschrieben werden.

Die Drehachse der Handhabungsvorrichtung 4 verläuft durch den Mittelpunkt 40 eines Umfangskreises 41. Die Drehachse der Handhabungsvorrichtung 4 steht senkrecht auf der Mittelachse 20 der linearen Fördereinrichtung 3. Die Handhabungsvorrichtung 4 weist jeweils sechs Aufnahmevorrichtungen bzw. Aufnahmen 42 bis 47 auf, die auf sechs sich radial erstreckenden Armen 48 bis 53 angeordnet sind. Die Aufnahmen 42 bis 47 sind dazu geeignet, durch beispielsweise Öffnen und Schließen CDs aufzunehmen und wieder abzulegen, und werden dafür durch eine nicht gezeigte Steuervorrichtung geeignet angesteuert.

Wie aus Figur 1 ersichtlich, liegen die Aufnahmen 42 bis 48 der Handhabungsvorrichtung 4 auf dem Umfangskreis 41 und sind auf dem Umfangskreis 41 gleichmäßig beabstandet. Die sechs Aufnahmen 42 bis 47 sind jeweils in einem Winkel von α = 60 ° auf dem Umfangskreis 41 vorgesehen.

Die Prozeßstationen 6A bis 6D bzw. 7A bis 7D sind den beiden Handhabungsvorrichtung 4 bzw. 5 zugeordnet, wie eingangs schon erwähnt. Aus diesem Grund werden in der Folge nur die Prozeßstationen 6A bis D beschrieben, wobei entsprechendes für die Prozeßstationen 7A bis D in Verbindung mit der Handhabungsvorrichtung 5 gilt.

Die Prozeßstationen 6A und 6C sind Belackungsstationen, die einen Drehteller und schwenkbare Belackungsdüsen aufweisen. Ferner besitzen sie Aufnahmen mit Aufnahmemittelpunkten 60A und 60C für die zu behandelnden CDs. Die Prozeßstationen 6B und 6D sind Kantenreiniger bzw. Edge-Cleaner mit einem Drehteller und einem Kantenabstreifer zur Reinigung der Kanten der CDs nach der Belackung. Die Prozeßstationen 6B und 6D besitzen ebenfalls Aufnahmen mit Aufnahmemittelpunkten 60B und 60D zur Aufnahme der CDs auf den Prozeßstationen.

Die Aufnahmemittelpunkte 60A bis 60D sind auf dem Umfangskreis 41 angeordnet, und sie liegen sich auf dem Umfangskreis 41 paarweise diametral gegenüber. So bilden die Aufnahmemittelpunkte 60A und 60C bzw. die Aufnahmemittelpunkte 60B und 60D jeweils ein Paar.

Die sich auf dem Umfangskreis 41 diametral gegenüberliegenden Prozeßstationen, sind vom gleichen Typ. Die Prozeßstationen 6A und 6C sind jeweils Belackungsstationen, und die Prozeßstationen 6B und 6D sind jeweils Kantenreinigungsstationen.

Die Aufnahmemittelpunkte 60A bis 60D sind so angeordnet, daß Aufnahmemittelpunkte von auf dem Umfangskreis unmittelbar benachbarten Prozeßstationen um den Winkel α = 60° beabstandet sind und die Aufnahmemittelpunkte jeweils zu einem Schnittpunkt der Mittelachse 20 der Fördereinrichtung mit dem Umfangskreis 41 ebenfalls um einen Winkel von α = 60° beabstandet sind.

Die Mittelpunkte 40, 65 der Umfangskreise 41, 66 der ersten und der zweiten Gruppe der Anlage 1 sind um das Dreifache des Abstandes d zwischen benachbarten Trägern auf der linearen Fördereinrichtung 3 beabstandet. Die Durchmesser der beiden Umfangskreise 41 und 66 sind gleich und entsprechen dem Zweifachen des Abstandes d zwischen benachbarten Trägern auf dem Förderband 3.

Die Anlage 1 ist mit einer bestimmten Anzahl von Prozeßstationen gezeigt, die aber nur beispielhaft ist und verändert werden kann. Auch muß es sich bei den Prozeßstationen nicht um Belackungs- und Kantenreinigungsstationen handeln, sondern es können auch andere Prozesse ausgeführt werden. Auch ist es nicht notwendig, daß unterschiedliche Prozesse vorgesehen werden. Ferner können statt CDs auch andere Substrate behandelt werden.

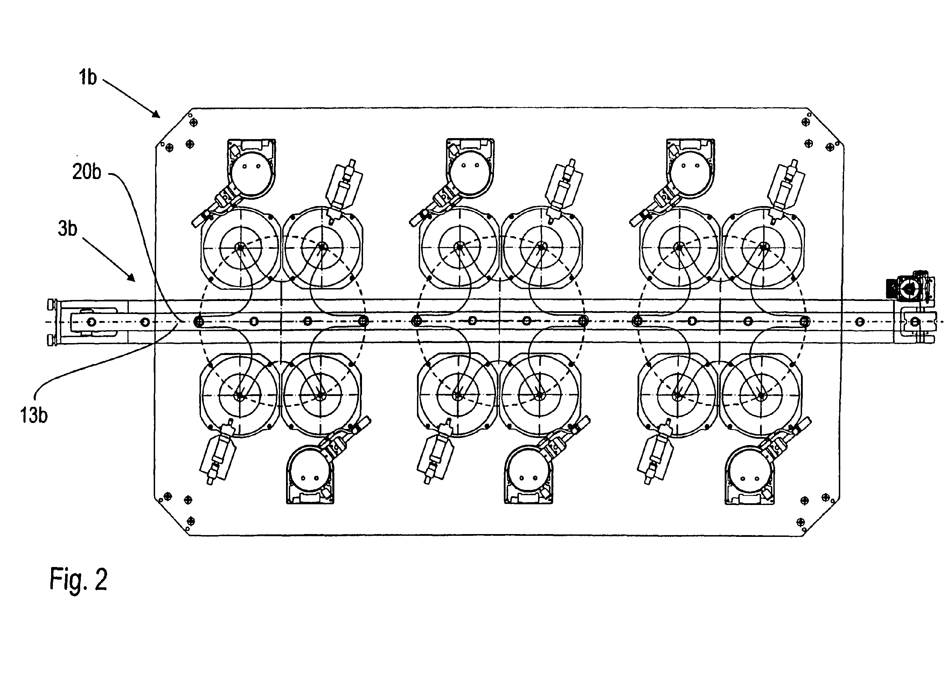

Figur 2 zeigt ein zweites Ausführungsbeispiel der Anlage 1b mit einer weiteren, dritten Handhabungsvorrichtung, die den Handhabungsvorrichtungen 4 und 5 des ersten Ausführungsbeispiels der Fig. 1 gleicht. Die dritte Handhabungsvorrichtung ist ebenfalls über der Fördereinrichtung 3b angeordnet, die im Vergleich zur linearen Fördereinrichtung 3 des ersten Ausführungsbeispiels länger ist. Die Drehachse der dritten Handhabungsvorrichtung steht senkrecht auf der Mittelachse 20b der Fördereinrichtung 3b. Die dritte Handhabungsvorrichtung bildet zusammen mit weiteren vier Prozeßstationen eine dritte Gruppe der Anlage 1b, wobei die vier Prozeßstationen wieder zwei Belackungsstationen und zwei Kantenreinigungsstationen sind.

Die Aufnahmemittelpunkte von CD-Aufnahmen der Prozeßstationen sowie die Aufnahmen der Handhabungsvorrichtungen der jeweiligen Gruppen sind auf jeweiligen Umfangskreisen angeordnet, deren Mittelpunkte auf der Mittelachse 20b der Fördereinrichtung 3b angeordnet sind und mit den Drehachsen der Handhabungsvorrichtungen zusammenfallen, wie aus Figur 2 ersichtlich ist.

Die Durchmesser der jeweiligen Umfangskreise sind gleich. Im Ausführungsbeispiel der Figur 2 entsprechen die Durchmesser der Umfangskreise dem Dreifachen des Abstandes d zwischen benachbarten Trägern 21 b bis 36b der Fördereinrichtung 3b. Die Mittelpunkte benachbarter Umfangskreise befinden sich auf der Mittelachse 20b der Fördereinrichtung 3b in einem Abstand, der dem Vierfachen des Abstandes d zwischen zwei benachbarten Trägern der Fördereinrichtung 3b entspricht.

Wie nachfolgend im Zusammenhang mit der Beschreibung der bevorzugten Betriebsweise der Anlage 1 bzw. 1b näher erläutert wird, unterscheiden sich das erste Ausführungsbeispiel und das zweite Ausführungsbeispiel auch bezüglich der Bestückung der Träger der Fördereinrichtung 3 bzw. 3b mit CDs.

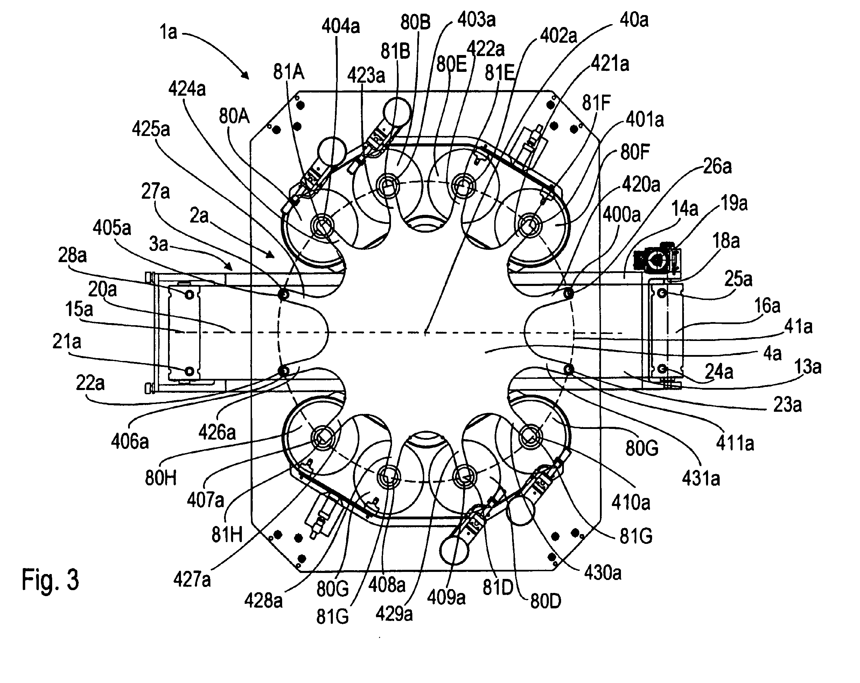

Figur 3 zeigt eine Anlage 1 a, die ein drittes Ausführungsbeispiel einer Vorrichtung 2a gemäß der vorliegenden Erfindung aufweist. Die Vorrichtung 2a weist eine lineare Fördereinrichtung 3a und eine drehbare Handhabungsvorrichtung 4a auf. Ferner weist die Anlage 1a Prozeßstationen 80A bis H auf.

Die lineare Fördereinrichtung 4a weist eine Bahn 14a auf, auf der ein Förderband 13a angeordnet ist. Wie bereits oben für das Förderband 13 des ersten Ausführungsbeispiels beschrieben, erstreckt sich auch das Förderband 13a zwischen zwei Umlenkenden 15a und 16a der linearen Fördereinrichtung 3a und wird mittels einer Antriebsrolle 18a am Umlenkende 16a durch einen geeigneten Antrieb 19a, wie beispielsweise einen gesteuerten Servomotor angetrieben.

Die Fördereinrichtung 3a weist eine Mittelachse 20a auf, die auch die Mittelachse des Förderbandes 13a ist. Auf dem Förderband 13a sind Träger für CDs angeordnet. In der Figur 3 sind Träger 21a bis 28a sichtbar. Die Träger sind paarweise symmetrisch zur Mittelachse angeordnet. Beispielsweise bilden die Träger 21 a und 28a oder die Träger 22a und 27a ein symmetrisches Paar bezüglich der Mittelachse 20a.

Die Handhabungsvorrichtung 4a ist über einen geeigneten Antrieb sowohl drehbar als auch höhenverstellbar und über dem Förderband 13a von oben gehalten angeordnet. Die Drehachse der Handhabungsvorrichtung 4a steht senkrecht auf der Mittelachse 20a der linearen Fördereinrichtung 3a. Die Handhabungsvorrichtung 4a weist zwölf Aufnahmen 400a bis 411 a an entsprechenden, sich radial erstreckenden Armen 420a bis 431a auf. Die Aufnahmen 400a bis 411 a dienen zum Aufnehmen und Ablegen von CDs und werden dafür durch eine nicht gezeigte Steuervorrichtung geeignet angesteuert.

Wie in Figur 3 gezeigt, sind die Aufnahmen 400a bis 411a auf einem Umfangskreis 41 a angeordnet, wobei die Drehachse der drehbaren Handhabungsvorrichtung 4a durch den Mittelpunkt 40a des Umfangskreises 41a verläuft. Die Aufnahmen 400a bis 411 a sind auf dem Umfangskreis mit einem Winkel α = 30° voneinander gleichmäßig beabstandet.

Der Durchmesser des Umfangskreises 41 a ist derart bemessen, daß in der in Figur 3 gezeigten Stellung der Vorrichtung 2a insgesamt zwei, bezüglich der Mittelachse 20a symmetrische Trägerpaare auf dem Förderband 13a auf dem Umfangskreis 41 a liegen. Konkret sind dies in der Figur 3 die Trägerpaare 23a, 26a und 22a, 27a. Demgemäß entspricht der Durchmesser des Umfangskreises 41 a dem Abstand zwischen den Trägern 22a und 26a bzw. zwischen den Trägern 23a und 27a.

Die in Fig. 3 gezeigten Prozeßstationen 80A bis 80H sind entweder Belakkungsstationen 80A bis 80D zur Belackung von CDs oder Kantenreinigungsstationen 80E bis 80H. Die Belackungsstationen 80A bis 80D weisen Drehteller, schwenkbare Belackungsdüsen und Aufnahmen mit jeweiligen Aufnahmemittelpunkten 81A bis 81 H für die zu behandelnden CDs auf. Die Kantenreinigungsstationen 80E bis 80H weisen Drehteller, Kantenabstreifer und Aufnahmen mit Aufnahmemittelpunkten 81 E bis 81 H auf.

Jeweilige Aufnahmemittelpunkte 81A bis 81 H der Prozeßstationen 80A bis 80H sind auf dem Umfangskreis 41a angeordnet, und liegen sich paarweise diametral auf dem Umfangskreis 41a gegenüber. Dabei sind die Prozeßstationen innerhalb dieser Paare vom gleichen Typ.

Ferner sind jeweils zwei gleichartige Prozeßstationen benachbart auf dem Umfangskreis 41a angeordnet, die über einen gemeinsamen Antrieb angetrieben werden, obwohl auch separate Antriebe vorgesehen sein können.

Im folgenden wird kurz die Betriebsweise der Vorrichtung 2 gemäß dem ersten Ausführungsbeispiel beschrieben.

Auf den Prozeßstationen befinden sich bereits behandelte CDs, die in den Belackungsstationen 6A, 6C beschichtet und deren Kanten in den Kantenreinigungsstationen gereinigt wurden.

Die Aufnahmen 42 bis 47 an den radialen Armen der Handhabungsvorrichtungen 4 befinden sich während der Behandlung der CDs in einer Zwischenposition, d.h. sie liegen zwischen benachbarten Prozeßstationen. Somit sind die Handhabungsvorrichtungen 4 und 5 derart positioniert, daß keine Aufnahmen 42 bis 47 über den Prozeßstationen angeordnet sind. Bezugnehmend auf die Figur 1 heißt dies, daß die Handhabungsvorrichtungen 4 und 5 aus ihrer gezeigten Position um α/2 = 30° herausgedreht sind.

Die Träger des Förderbandes werden am Umlenkende 15 durch die Beladestation mit zu behandelnden CDs bestückt. Nach dem Bestückungsvorgang sollen nur Träger des Förderbandes 13 bestückt sein, die auf den Umfangskreisen 41 und 66 positioniert werden. Bei der Anlage 1 der Fig. 1 erfolgt dies derart, daß zunächst ein Träger am Umlenkende 15 durch die Beladestation bestückt wird, der nächste nicht bestückt wird, die zwei folgenden Träger wieder bestückt werden, nochmals ein Träger nicht bestückt wird und schließlich noch ein Träger mit einer zu behandelnden CD bestückt wird. Das Förderband wird dazu immer um einen Abstand d weiter getaktet, bis schließlich alle mit einer CD bestückten Träger auf einem der Umfangskreise 41 oder 66 angeordnet sind. In der Figur 1 sind dies die Träger 22, 24, 25 und 27.

Während des Bestückens der Träger werden bereits behandelte CDs aus einem vorangegangen Arbeitszyklus am Umlenkende 16 durch die Entladestation vom Förderband entnommen.

Sobald die bestückten Träger 22, 24, 25 und 27 auf den Umfangskreisen 41 bzw. 66 angeordnet sind, werden die Handhabungsvorrichtungen 4 und 5 in die in der Figur 1 gezeigte Position gedreht, in der die Aufnahmen 42 bis 47 entweder über den Aufnahmemittelpunkten 60A bis 60D oder über den Trägern 22 und 24 angeordnet sind. Entsprechendes gilt für die zweite Gruppe der Anlage 1 bestehend aus der Handhabungsvorrichtung 5, den vier Prozeßstationen 7A bis 7D und dem Förderband 13.

In dieser Position werden die Aufnahmen 42 bis 47 zum Ergreifen der CDs abgesenkt und anschließend wieder angehoben. Dabei werden die unbehandelten CDs von den Trägern und die behandelten CDs von den Aufnahmen der Prozeßstationen simultan aufgenommen und gemeinsam angehoben.

Mit den aufgenommenen CDs wird die Handhabungsvorrichtungen 4 im Uhrzeigersinn um einen Winkel α = 60° gedreht. Dabei wird beispielsweise die vom Träger 22 aufgenommene, unbehandelte CD zum Aufnahmemittelpunkt 60A der Prozeßstation 6A und die von der Belackungsstation 6A aufgenommene CD zur Kantenreinigungsstation 6B transportiert usw..

In der neuen Position werden die Aufnahmen abgesenkt und legen die CDs entweder auf den Aufnahmemittelpunkten der Prozeßstationen oder auf den Trägern des Förderbandes 13 ab.

Nachdem die CDs auf den Trägern und den Prozeßstationen abgelegt sind, wird die Handhabungsvorrichtungen 4 wieder in eine Zwischen- bzw. Parkposition gedreht, in der die Arme 48 bis 53 und damit die Aufnahmen der Handhabungsvorrichtung zwischen benachbarten Prozeßstationen angeordnet sind. Gleiches gilt für die zweite Handhabungsvorrichtung 5 und deren Aufnahmen.

Während der Bearbeitung der CDs in den Belackungs- und Kantenreinigungsstationen wird das Förderband 13 entladen und neu mit zu behandelnden CDs bestückt, wie zuvor beschrieben.

Die Anlage 1 b der Figur 2 unterscheidet sich von der Anlage 1 der Figur 1 dahingehend, daß eine dritte Gruppe bestehend aus einer dritten Handhabungsvorrichtung und vier entsprechenden Prozeßstationen entlang der verlängerten Fördereinrichtung 3b angeordnet ist.

Daraus ergibt sich ein Unterschied beim Betrieb der Be- und Entladevorrichtung der Fig. 2 gegenüber dem der Fig. 1. Die Träger des Förderbandes werden durch die Beladestation am Umlenkende 15b derart mit CDs bestückt, daß zwischen zwei mit CDs bestückten Trägern, die auf einem gemeinsamen Umfangskreis einer jeweiligen Gruppe angeordnet werden, zwei Träger frei bleiben, die nach der Bestückung des Förderbandes unter den Handhabungsvorrichtungen liegen. Nachdem also der erste Träger mit einer CD bestückt wurde, werden zwei Träger freigelassen, dann wieder zwei Träger bestückt, dann wieder zwei Träger freigelassen usw.. Für die Aufnahme und die Ablage der CDs durch die Aufnahmen der Handhabungsvorrichtungen wird das Förderband 13b in die in der Figur 2 gezeigten Stellung positioniert, wobei die bestückten Träger auf den jeweiligen Umfangskreisen der Handhabungsvorrichtungen angeordnet sind.

Die drei Handhabungsvorrichtungen werden dann zum Transportieren der CDs auf den Prozeßstationen und auf den Trägern gesteuert, wie im Zusammenhang mit der Betriebsweise der Anlage der Fig. 1 beschrieben wurde.

Bei der Anlage 1a der Figur 3 ist der Gedanken der Erfindung weitergeführt, indem für die eine Handhabungsvorrichtung 4a insgesamt zwölf Aufnahmen 400a bis 411 a vorgesehen sind. In der in Figur 3 gezeigten Position können durch die Aufnahmen simultan vier unbehandelte CDs von den Trägern 22a, 27a, 23a und 26a und von den Aufnahmemittelpunkten 81A bis 81 H der Prozeßstationen 80A bis 80H aufgenommen werden. Nach dem Anheben der CDs wird die Handhabungsvorrichtung 4a um einen Winkel 2α = 60° gedreht, also den doppelten Winkelabstand zwischen zwei benachbarten Aufnahmen auf dem Umfangskreis 41 a. Somit werden simultan insgesamt vier CDs den Belackungsstationen 80A bis 80D, vier CDs den Kantenreinigungsstationen 80E bis 80H und vier behandelte CDs den Trägern 22a, 27a, 23a und 26a zugeführt. Nach der Ablage der CDs wird die Handhabungsvorrichtung 4a wie bei den vorhergehenden Ausführungsbeispielen in eine Zwischenstellung gedreht, in der die Aufnahmen zwischen den Prozeßstationen bzw. den Trägern bzw. einer Prozeßstation und einem Träger angeordnet sind. Sodann können die behandelten CDs zur Entladestation transportiert werden, die Träger mittels der Beladestation mit neu zu behandelnden CDs bestückt werden, und die CDs auf den Prozeßstationen behandelt werden.

Die Erfindung wurde anhand von bevorzugten Ausführungsbeispielen der Erfindung beschrieben, ohne jedoch auf die speziellen Ausführungsbeispiele beschränkt sein.

Beispielsweise können die Anlagen der Fig.1 und Fig. 2 um weitere Gruppen bestehend aus einer Handhabungsvorrichtung ähnlich zu den Handhabungsvorrichtungen 4 und 5 mit einer geeigneten Anzahl von Prozeßstationen erweitert werden, und zwar bei entsprechender Verlängerung der linearen Fördereinrichtung 3. Dabei muß darauf geachtet werden, daß die Durchmesser der jeweiligen Umfangskreise in einem geeigneten Verhältnis zu den Abständen d von benachbarten Trägern auf dem Förderband 13, 13a bzw. 13b stehen, und daß nur Träger mit CDs bestückt werden, die dann auf den entsprechenden Umfangskreisen angeordnet werden können. Weiter können statt CDs auch andere Substrate bearbeitet werden, oder die lineare Fördereinrichtung könnte anders realisiert sein als durch das Förderband 13, 13a bzw. 13b.

## Patentansprüche

1. Anlage mit wenigstens zwei Prozeßstationen und mit einer Vorrichtung (1; 1 a; 1b) zum Be- und Entladen von Substraten auf die bzw. von den Prozeßstationen, wobei die Vorrichtung folgendes aufweist: eine Fördereinrichtung (3; 3a; 3b) zum linearen Transport der Substrate und wenigstens eine drehbaren Handhabungsvorrichtung (4, 5; 4a) zum Transport der Substrate zwischen der Fördereinrichtung (3; 3a; 3b) und den wenigstens zwei Prozeßstationen (6A bis D, 7A bis D; 80A bis H), **dadurch gekennzeichnet, daß** die Fördereinrichtung (3; 3a; 3b) zwischen den wenigstens zwei Prozeßstationen (6A bis D, 7A bis D; 80A bis H) und die wenigstens eine Handhabungsvorrichtung (4, 5; 4a) zum Be- und Entladen von Substraten auf die bzw. von den wenigstens zwei Prozeßstationen oberhalb der Fördereinrichtung (3; 3a; 3b) angeordnet ist.

2. Anlage nach Anspruch 1, **dadurch gekennzeichnet, daß** der Drehpunkt (40, 65; 40a) der Handhabungsvorrichtung (4, 5; 4a) auf der Mittelachse (20; 20b; 20a) der Fördereinrichtung (3; 3a; 3b) liegt.

3. Anlage nach Anspruch 1 oder 2, **dadurch gekennzeichnet, daß** die Handhabungsvorrichtung (4, 5; 4a) auf einem Umfangskreis (41, 66; 41a) angeordnete Aufnahmen (42 bis 47; 400a bis 411a) für die Substrate aufweist.

4. Anlage nach Anspruch 3, **dadurch gekennzeichnet, daß** die Aufnahmen (42 bis 47; 400a bis 411 a) auf dem Umfangskreis (41, 66; 41a) gleichmäßig beabstandet sind.

5. Anlage nach einem der Ansprüche 3 oder 4, **dadurch gekennzeichnet, daß** die Aufnahmen (42 bis 47; 400a bis 411a) an radialen Armen (48 bis 53; 420 bis 431) der Handhabungsvorrichtung (4, 5; 4a) angeordnet sind.

6. Anlage nach einem der vorhergehenden Ansprüche, **dadurch gekennzeichnet, daß** die Fördereinrichtung (3; 3a; 3b) ein Förderband (13; 13a; 13b) aufweist.

7. Anlage nach Anspruch 6, **dadurch gekennzeichnet, daß** sich das Förderband (13; 13a; 13b) zwischen einer Beladestation und einer Entladestation erstreckt.

8. Anlage nach Anspruch 6 oder 7, **dadurch gekennzeichnet, daß** das Förderband (13; 13a; 13b) Träger (21 bis 28; 21a bis 28a) für die Substrate aufweist.

9. Anlage nach Anspruch 8, **dadurch gekennzeichnet, daß** die Träger (21 bis 28; 21 a bis 28a) in Bewegungsrichtung des Förderbandes (13; 13a; 13b) gleichmäßig beabstandet sind.

10. Anlage nach Anspruch 8 oder 9, **dadurch gekennzeichnet, daß** die Träger (21 bis 28) auf der Mittelachse (20; 20a; 20b) des Förderbandes (13; 13b) angeordnet sind.

11. Anlage nach Anspruch 8 oder 9, **dadurch gekennzeichnet, daß** jeweils wenigstens zwei Träger (21a bis 28b) symmetrisch zur Mittelachse (20a) des Förderbandes (13a) angeordnet sind.

12. Anlage nach Ansprüchen 3, 4 oder 5 mit einem der Ansprüche 8 bis 11, **dadurch gekennzeichnet, daß** wenigstens zwei Träger (21 bis 28; 21 a bis 28a) zum Be- und Entladen der Substrate auf dem Umfangskreis (41, 66; 41 a) anordnenbar sind.

13. Anlage nach Anspruch 3, **dadurch gekennzeichnet, daß** Aufnahmemittelpunkte (60A bis D; 81A bis H) der Prozeßstationen (6A bis D; 80A bis H) auf dem Umfangskreis (41; 41a) angeordnet sind.

14. Anlage nach Anspruch 12 oder 13, **dadurch gekennzeichnet, daß** die Prozeßstationen (6A bis D, 7A bis D; 80A bis H) paarweise diametral auf dem Umfangskreis (41, 66; 41a) gegenüberliegend angeordnet sind.

15. Anlage nach Anspruch 14, **dadurch gekennzeichnet, daß** die Prozeßstationen (6A bis D, 7A bis D; 80A bis H) innerhalb der Paare vom gleichen Typ sind.

16. Anlage nach Anspruch 3 oder nach einem der Ansprüche 4 bis 15 mit Anspruch 3, **dadurch gekennzeichnet, daß** auf dem Umfangskreis (41a) benachbart angeordnete Prozeßstationen (80A bis H) mit dem gleichen Antrieb angetrieben werden.

17. Anlage nach Ansprüchen 3, 4 oder 5 mit einem der Ansprüche 8 bis 12, **dadurch gekennzeichnet, daß** die Anzahl der Aufnahmen (42 bis 47; 400a bis 411 a) der Handhabungsvorrichtung (4; 4a) der Anzahl der auf dem Umfangskreis (41; 41 a) anordnenbaren Träger (22, 24; 22a, 23a, 26a, 27a) zum Be- und Entladen und der Prozeßstationen (6A bis D; 80A bis H) entspricht.

18. Anlage nach Anspruch 17, **dadurch gekennzeichnet, daß** beim Be- und Entladen alle Aufnahmen (42 bis 47; 400a bis 411 a) entweder über den Trägern (22, 24, 25, 27; 22a, 23a, 26a, 27a) auf der Fördereinrichtung (3; 3a; 3b) oder über den Aufnahmemittelpunkten der Prozeßstationen (6A bis D, 7A bis D; 80A bis H) anordenbar sind.

19. Anlage nach einem der vorhergehenden Ansprüche, **gekennzeichnet durch** eine Steuervorrichtung zum simultanen Öffnen und Schließen der Aufnahmen (42 bis 47; 400a bis 411a).

## Claims

1. Plant with at least two process stations and with a device (1; 1a; 1b) for loading substrates onto and unloading substrates from the process stations, wherein the device comprises the following: a conveying device (3; 3a; 3b) for linear transport of the substrates and at least one rotatable handling device (4, 5; 4a) for transport of the substrates between the conveying device (3; 3a; 3b) and the at least two process stations (6A to D, 7A to D; 80A to H), **characterised in that** the conveying device (3; 3a, 3b) is arranged between the at least two process stations (6A to D, 7A to D; 80A to H) and the at least one handling device (4, 5; 4a) for loading substrates onto and unloading substrates from the at least two process stations is arranged above the conveying device (3; 3a; 3b).

2. Plant according to claim 1, **characterised in that** the fulcrum (40, 65; 40a) of the handling device (4, 5; 4a) lies on the centre axis (20; 20b; 20a) of the conveying device (3; 3a; 3b).

3. Plant according to claim 1 or 2, **characterised in that** the handling device (4, 5; 4a) has receptacles (42 to 47; 400a to 411a), which are arranged on a circumferential circle (41, 66; 41 a), for the substrates.

4. Plant according to claim 3, **characterised in that** the receptacles (42 to 47; 400a to 411a) are equidistantly spaced apart on the circumferential circle (41; 66; 41 a).

5. Plant according to one of claims 3 and 4, **characterised in that** the receptacles (42 to 47; 400a to 411a) are arranged at radial arms (48 to 53; 420 to 431) of the handling device (4, 5; 4a).

6. Plant according to one of the preceding claims, **characterised in that** the conveying device (3; 3a; 3b) comprises a conveyor belt (13; 13a; 13b).

7. Plant according to claim 6, **characterised in that** the conveyor belt (13; 13a; 13b) extends between a loading station and an unloading station.

8. Plant according to claim 6 or 7, **characterised in that** the conveyor belt (13; 13a; 13b) has carriers (21 to 28; 21 a to 28a) for the substrates.

9. Plant according to claim 8, **characterised in that** the carriers (21 to 28; 21 a to 28a) are equidistantly spaced apart in movement direction of the conveyor belt (13; 13a; 13b).

10. Plant according to claim 8 or 9, **characterised in that** the carriers (21 to 28) are arranged on the centre axis (20; 20a; 20b) of the conveyor belt (13a; 13b).

11. Plant according to claim 8 or 9, **characterised in that** in each instance at least two carriers (21a to 28b) are arranged symmetrically with respect to the centre axis (20a) of the conveyor belt (13a).

12. Plant according to claim 3, 4 or 5 together with one of claims 8 to 11, **characterised in that** at least two carriers (21 to 28; 21 a to 28a) for loading and unloading the substrates can be arranged on the circumferential circle (41, 66; 41 a).

13. Plant according to claim 3, **characterised in that** receiving centre points (60A to D; 81A to H) of the process stations (6A to D; 80A to H) are arranged on the circumferential circle (41; 41 a).

14. Plant according to claim 12 or 13, **characterised in that** the process stations (6A to D, 7A to D; 80A to H) are arranged diametrically opposite in pairs on the circumferential circle (41, 66; 41 a).

15. Plant according to claim 14, **characterised in that** the process stations (6A to D, 7A to D; 80A to H) within the pairs are of the same type.

16. Plant according to claim 3 or according to one of claims 4 to 15 together with claim 3, **characterised in that** process stations (80A to H) arranged adjacent to one another on the circumferential circle (41 a) are driven by the same drive.

17. Plant according to claim 3, 4 or 5 together with one of claims 8 to 12, **characterised in that** the number of receptacles (42 to 47; 400a to 411a) of the handling device (4; 4a) corresponds with the number of carriers (22, 24; 22a, 23a, 26a, 27a), which can be arranged on the circumferential circle (41; 41a), for loading and unloading and of the process stations (6A to D; 80A to H).

18. Plant according to claim 17, **characterised in that** during the loading and unloading all receptacles (42 to 47; 400a to 411 a) can be arranged either above the carriers (22, 24, 25, 27; 22a, 23a, 26a, 27a) on the conveying device (3; 3a; 3b) or above the receiving centre points of the process stations (6A to D, 7A to D; 80A to H).

19. Plant according to one of the preceding claims, **characterised by** a control device for simultaneous opening and closing of the receptacles (42 to 47; 400a to 411a).

## Revendications

1. Installation comprenant au moins deux postes du processus et un dispositif (1 ; 1a ; 1b) pour le chargement et le déchargement de substrats sur ou à partir des postes de processus, le dispositif présentant les éléments suivants : un dispositif de transport (3 ; 3a ; 3b) pour le transport linéaire des substrats et au moins un dispositif de manipulation (4, 5 ; 4a) rotatif pour le transport des substrats entre le dispositif de transport (3 ; 3a ; 3b) et les au moins deux postes de processus (6A à D, 7A à D ; 80A à H), **caractérisée en ce que** le dispositif de transport (3 ; 3a ; 3b) est disposé entre les au moins deux postes de processus (6A à D, 7A à D ; 80A à H) et le au moins un dispositif de manipulation (4, 5 ; 4a) pour le chargement et le déchargement de substrats sur ou à partir des au moins deux postes de processus est disposé au-dessus du dispositif de transport (3 ; 3a ; 3b).

2. Installation selon la revendication 1, **caractérisée en ce que** le point de rotation (40, 65, 40a) du dispositif de manipulation (4, 5 ; 4a) est disposé sur l'axe médian (20 ; 20a ; 20b) du dispositif de transport (3 ; 3a ; 3b).

3. Installation selon la revendication 1 ou 2, **caractérisée en ce que** le dispositif de manipulation (4, 5 ; 4a) présente des logements (42 à 47 ; 400a à 411a) disposés sur un cercle périphérique (41, 66 ; 41a) pour les substrats.

4. Installation selon la revendication 3, **caractérisée en ce que** les logements (42 à 47 ; 400a à 411a) sont espacés régulièrement sur le cercle périphérique (41, 66 ; 41a).

5. Installation selon l'une quelconque des revendications 3 ou 4, **caractérisée en ce que** les logements (42 à 47 ; 400a à 411a) sont disposés sur des bras (48 à 53 ; 420 à 431) radiaux du dispositif de manipulation (4, 5 ; 4a).

6. Installation selon l'une quelconque des revendications précédentes, **caractérisée en ce que** le dispositif de transport (3 ; 3a ; 3b) présente une bande transporteuse (13 ; 13a ; 13b).

7. Installation selon la revendication 6, **caractérisée en ce que** la bande transporteuse (13 ; 13a ; 13b) s'étend entre une station de chargement et une station de déchargement.

8. Installation selon la revendication 6 ou 7, **caractérisée en ce que** la bande transporteuse (13 ; 13a ; 13b) présente des supports (21 à 28 ; 21a à 28a) pour les substrats.

9. Installation selon la revendication 8, **caractérisée en ce que** les supports (21 à 28 ; 21a à 28a) sont espacés régulièrement dans le sens de déplacement de la bande transporteuse (13 ; 13a ; 13b).

10. Installation selon la revendication 8 ou 9, **caractérisée en ce que** les supports (21 à 28) sont disposés sur l'axe médian (20 ; 20a ; 20b) de la bande transporteuse (13 ; 13b).

11. Installation selon la revendication 8 ou 9, **caractérisée en ce qu'**à chaque fois au moins deux supports (21a à 28b) sont disposés de façon symétrique par rapport à l'axe médian (20) de la bande transporteuse (13a).

12. Installation selon les revendications 3, 4 ou 5 avec l'une des revendications 8 à 11, **caractérisée en ce que** au moins deux supports (21 à 28 ; 21a à 28a) pour le chargement et le déchargement des substrats peuvent être disposés sur le cercle périphérique (41, 66 ; 41a).

13. Installation selon la revendication 3, **caractérisée en ce que** des centres de logement (60A à D ; 81A à H) des postes de processus (6A à D ; 80A à H) sont disposés sur le cercle périphérique (41 ; 41a).

14. Installation selon la revendication 12 ou 13, **caractérisée en ce que** les postes de processus (6A à D, 7A à D ; 80A à H) sont disposés de façon diamétralement opposée par paire sur le cercle périphérique (41, 66 ; 41a).

15. Installation selon la revendication 14, **caractérisée en ce que** les postes de processus (6A à D, 7A à D ; 80A à H) sont du même type à l'intérieur des paires.

16. Installation selon la revendication 3 ou selon l'une quelconque des revendications 4 à 15 avec la revendication 3, **caractérisée en ce que** des postes de processus (80A à H) disposés de façon voisine sur le cercle périphérique (41a) sont entraînés avec le même entraînement.

17. Installation selon la revendication 3, 4 ou 5 avec l'une quelconque des revendications 8 à 12, **caractérisée en ce que** le nombre des logements (42 à 47 ; 400a à 411a) du dispositif de manipulation (4 ; 4a) correspond au nombre des supports (22, 24, 22a, 23a, 26a, 27a) pouvant être disposés sur le cercle périphérique (41 ; 41a) pour le chargement et le déchargement et des postes de processus (6A à D ; 80A à H) .

18. Installation selon la revendication 17, **caractérisée en ce que**, lors du chargement et le déchargement, tous les logements (42 à 47 ; 400a à 411a) peuvent être disposés soit au-dessus des supports (22, 24, 25, 27, 28, 22a, 23a, 26a, 27a) sur le dispositif de transport (3 ; 3a ; 3b) ou au-dessus des centres de logement des postes de processus (6A à D ; 80A à H).

19. Installation selon l'une quelconque des revendications précédentes, **caractérisée par** un dispositif de commande pour l'ouverture et la fermeture simultanées des logements (42 à 47 ; 400a à 411a).
